# EUROPÄISCHE PATENTSCHRIFT

(11) **EP 3 483 675 B1**
(45) Veröffentlichungstag und Bekanntmachung des Hinweises auf die Patenterteilung: **24.02.2021**
(21) Anmeldenummer: 18202320.0
(22) Anmeldetag: 24.10.2018
(51) Int. Cl.: G05B 9/03, G05B 19/042

(54) **EINGANGSSCHALTUNG ZUM FEHLERSICHEREN EINLESEN EINES ANALOGEN EINGANGSSIGNALS**
INPUT CIRCUIT FOR THE FAIL-SAFE READING OF AN ANALOG INPUT SIGNAL
CIRCUIT D'ENTRÉE PERMETTANT UNE LECTURE PROTÉGÉE CONTRE LES ERREURS D'UN SIGNAL D'ENTRÉE ANALOGIQUE

(30) Priorität: 14.11.2017 DE 102017126754
(43) Veröffentlichungstag der Anmeldung: 15.05.2019
(73) Patentinhaber: Pilz GmbH & Co. KG, 73760 Ostfildern (DE)
(72) Erfinder: Veil, Richard, 73760 Ostfildern (DE); Harrer, Bernd, 73760 Ostfildern (DE)
(74) Vertreter: Schäperklaus, Jochen

(56) Entgegenhaltungen:
- WO-A1-2009/155993
- DE-A1- 19 722 872
- John Hamburger Hamburger Dobkin ET AL: "Analog Circuit Design Volume Three", , 1. Januar 2015 (2015-01-01), XP55567797, Saint Louis ISBN: 978-0-12-800001-4 Gefunden im Internet: URL:https://www.analog.com/media/en/techni cal-documentation/application-notes/an105f a.pdf [gefunden am 2019-03-12]

## Beschreibung

Die vorliegende Erfindung betrifft eine Eingangsschaltung zum fehlersicheren Einlesen eines analogen Eingangssignals zumindest eines Sensors nach dem Oberbegriff des Anspruchs 1. Darüber hinaus betrifft die Erfindung eine Sicherheitsschaltvorrichtung zum sicheren Abschalten eines Verbrauchers in einer automatisiert arbeitenden technischen Anlage, umfassend eine Eingangsschaltung, die zum fehlersicheren Einlesen eines analogen Eingangssignals eines analogen Sensors und zum Wandeln des analogen Eingangssignals in mindestens ein analoges Ausgangssignal eingerichtet ist, einen Analog-Digital-Wandler, der dazu ausgebildet ist, das mindestens eine Ausgangssignal der Eingangsschaltung in mindestens ein digitales Signal zu wandeln, eine Steuerungs- und Auswerteeinheit, die dazu ausgebildet ist, das digitale Signal des zumindest einen Analog-Digital-Wandlers zu empfangen und zu verarbeiten, sowie zumindest ein Stellglied das an die Steuerungs- und Auswerteeinheit und an den Verbraucher angeschlossen ist und in Abhängigkeit von dem digitalen Signal ansteuerbar ist.

Automatisiert arbeitende technische Anlagen haben seit vielen Jahren eine zunehmende Bedeutung und Verbreitung erlangt. Zu nennen sind in diesem Zusammenhang zum Beispiel automatisiert arbeitende Anlagen in industriellen Produktionsprozessen, automatisiert arbeitende Anlagen zur Personen- oder Güterbeförderung oder Anlagen, die in der Gebäudeautomatisierungstechnik eingesetzt werden. Bei derartigen technischen Anlagen spielen Sicherheitsaspekte zur Vermeidung von Personen- und Sachschäden eine immer größer werdende Rolle, da von einer automatisiert arbeitenden technischen Anlage unterschiedliche Gefahren ausgehen können, die insbesondere durch eine Fehlbedienung oder durch einen Fehler im Arbeitsablauf der Anlage hervorgerufen werden können.

Typische Maßnahmen zur Absicherung von automatisiert arbeitenden technischen Anlagen sind zum Beispiel die Einrichtung von Schutzbereichen mit Hilfe von Lichtschranken, Lichtgittern, Schutzzäunen etc. sowie das Bereitstellen von Not-Aus-Schaltern, die eine sichere Abschaltung der Anlage (oder eines Anlagenteils) ermöglichen. Eine zentrale Komponente einer automatisiert arbeitenden technischen Anlage ist eine Sicherheitsschaltvorrichtung, die zum Beispiel über einen Feldbus mit Sensoren und Stellgliedern (Aktoren) in Kommunikationsverbindung steht. Eine Sicherheitsschaltvorrichtung kann insbesondere eine Auswerte- und Steuereinheit umfassen, die als speicherprogrammierbare Sicherheitssteuerung ausgeführt sein kann. Neben digitalen Eingängen zum Empfangen digitaler Eingangssignale kann eine Sicherheitsschaltvorrichtung auch analoge Eingänge aufweisen, über die der Sicherheitsschaltvorrichtung analoge Messsignale eines Sensors zugeführt werden können. Lediglich beispielhaft sollen an dieser Stelle analoge Druck-, Temperatur-, Drehzahl- oder auch Durchflusssensoren genannt werden, die der Sicherheitsschaltvorrichtung analoge Messsignale, insbesondere analoge Stromsignale, bereitstellen können. Ein Beispiel für einen Sensor, der direkt an einen analogen Eingang einer Sicherheitsschaltvorrichtung angeschlossen werden kann, ist ein so genannter 2-Leitersensor, bei dem die Energieversorgung und das Messsignal über eine gemeinsame Leitung geführt werden. Darüber hinaus finden auch 3-Leitersensoren und 4-Leitersensoren Anwendung.

Die von dem Sensor während des Betriebs erfassten realen Messwerte werden in geeigneter Weise von dem Sensor auf einen Pegel normiert, so dass der Sensor ein normiertes analoges Messsignal ausgibt, das sich aus der Art des Signals (zum Beispiel ein elektrischer Strom oder eine elektrische Spannung) und dem Betrag (zum Beispiel gemäß der Norm EN 61131-2:2007 ein Betrag von 0 mA bis 20 mA bei einem Stromsignal oder 0 V bis 10 V bei einem Spannungssignal) zusammensetzt und ein analoges Eingangssignal für eine Eingangsschaltung der Sicherheitsschaltvorrichtung bildet.

Zur Übertragung analoger Sensorsignale an eine Sicherheitsschaltvorrichtung werden bevorzugt Stromschnittstellen mit einer Hin- und Rückleitung und niederohmigen Eingängen verwendet. Diese zeichnen sich insbesondere dadurch aus, dass sie auch bei relativ langen Leitungen störunempfindlich sind. Es hat sich gezeigt, dass sich die Signalart 0 mA bis 20 mA nicht beziehungsweise nur bedingt für die oben erwähnten 2-Leitersensoren eignet, da bei einem Strom von 0 mA (d.h. am Messbereichsanfang) kein Strom fließt und der Sensor somit eine externe Stromversorgung benötigt, damit er betrieben werden kann. Daher wird bei Sensoren, die als Messsignal ein analoges Stromsignal liefern, häufig ein nutzbarer Signalbereich zwischen 4 mA und 20 mA verwendet. Bei einem Null-Signal des Sensors fließt somit immer noch ein Strom von 4 mA, so dass der Sensor im gesamten Signalbereich (also auch am Messbereichsanfang) mit Energie versorgt werden kann. Die Eingangsschaltung zum fehlersicheren Einlesen eines analogen Eingangssignals ist typischerweise dazu eingerichtet, Ströme in einem Bereich zwischen 0 mA und 25 mA zu messen. Werden Eingangssignale erfasst, die außerhalb des eigentlichen Arbeitsbereichs zwischen 4 mA und 20 mA liegen, werden diese als Fehler gewertet. Wenn zum Beispiel in der Hin- oder Rückleitung ein Leitungsbruch auftritt, wird die Signalübertragung zur Sicherheitsschaltvorrichtung unterbrochen. Die Eingangsschaltung misst einen Strom von 0 mA, der außerhalb des Arbeitsbereichs liegt, so dass dieser Fehler erkannt werden kann.

Gemäß der Norm EN 61131-2:2007 muss der Eingangswiderstand der Eingangsschaltung ≤ 300 Ohm sein. Wenn an diesem Eingangswiderstand eine Spannung von 24 V anliegt, wird an diesem eine elektrische Leistung von 1,92 W umgesetzt. Bei einer Spannung von 30 V liegt die an dem Eingangswiderstand umgesetzte elektrische Leistung demgegenüber bei 3 W. Eine bei analogen Schaltungen häufig verwendete Widerstandsbauform sind so genannte Mini-MELF-Widerstände, die in SMD-Bauweise ausgeführt sind. Typischerweise sind derartige Mini-MELF-Widerstände etwa 3,6 mm lang und haben einen Durchmesser von etwa 1,4 mm. Sie weisen eine typische Verlustleistung von 0,25 W auf. Um den Eingangswiderstand der Eingangsschaltung entsprechend der oben genannten Norm auf 300 Ohm bei einer Eingangsspannung in Höhe von 30 V auszulegen, müssten 12 derartige Mini-MELF-Widerstände verwendet werden. Ein einzelner, entsprechend groß dimensionierte Widerstand (Shunt-Widerstand), der zur Strommessung verwendet werden kann, wäre ebenfalls möglich. Aufgrund des relativ großen Platzbedarfs wird der Shunt-Widerstand, an dem ein Spannungsabfall zur Bestimmung des durch die Eingangsschaltung fließenden elektrischen Stroms gemessen werden kann, üblicherweise nicht für eine Überspannung von 30 V ausgelegt.

Beispielsweise werden von der Anmelderin der vorliegenden Erfindung unter der Bezeichnung "PSSu" analoge Eingangsmodule mit einer Eingangsschaltung angeboten, die einen Eingangswiderstand (Shunt-Widerstand) von 115 Ohm aufweist und für einen maximalen Dauerstrom von 40 mA ausgelegt ist. Der maximale Eingangsstrom wird bereits bei einer Eingangsspannung von 4,6 V erreicht. Wird eine höhere Eingangsspannung angelegt, kann der Shunt-Widerstand unter Umständen zerstört werden, so dass das Eingangsmodul nicht mehr funktionsfähig ist und daher ausgetauscht werden muss.

Die Erfindung macht es sich zur Aufgabe, eine Eingangsschaltung zum fehlersicheren Einlesen eines analogen Eingangssignals zumindest eines Sensors sowie eine Sicherheitsschaltvorrichtung der eingangs genannten Art zur Verfügung zu stellen, bei denen der Schutz der Eingangsschaltung vor Beschädigungen, die insbesondere durch das Auftreten von Überspannungen verursacht werden können, verbessert ist.

Eine gattungsgemäße Schaltungsanordnung ist zum Beispiel aus der DE 197 22 872 A1 bekannt.

Die Lösung dieser Aufgabe liefert eine Eingangsschaltung der eingangs genannten Art mit den Merkmalen des kennzeichnenden Teils des Anspruchs 1. Hinsichtlich der Sicherheitsschaltvorrichtung wird diese Aufgabe durch eine gattungsgemäße Sicherheitsschaltvorrichtung mit den Merkmalen des kennzeichnenden Teils des Anspruchs 10 gelöst. Die Unteransprüche betreffen vorteilhafte Weiterbildungen der Erfindung.

Eine erfindungsgemäße Eingangsschaltung zeichnet sich u.a. dadurch aus, dass die Eingangsschaltung eine Prüfeinrichtung umfasst, die an die beiden Strom-Messsignal-Wandler angeschlossen ist und die dazu eingerichtet ist, das erste Ausgangssignal mit dem zweiten Ausgangssignal zu vergleichen, um Fehler der Strom-Messsignal-Wandler zu erkennen, wenn Abweichungen zwischen den Ausgangssignalen einen vorbestimmten oder vorbestimmbaren Grenzwert überschreiten, und dass die Strombegrenzungseinrichtung einen Längsregler bildet, der einen Bipolartransistor sowie eine Z-Diode mit einem Vorwiderstand umfasst.

Die Erfindung stellt eine robuste, fehlersichere analoge Eingangsschaltung bereit, die analoge Stromsignale eines Sensors empfangen und verarbeiten kann. Aufgrund der in den ersten Strom-Messsignal-Wandler integrierten Strombegrenzungseinrichtung kann der durch die Eingangsschaltung fließende Strom - insbesondere im Falle einer Überspannung - wirksam begrenzt werden, so dass zum Beispiel Beschädigungen der Bauteilkomponenten der Strom-Messsignal-Wandler der Eingangsschaltung wirksam verhindert werden können. Mit Hilfe der Prüfeinrichtung, die an die beiden Strom-Messsignal-Wandler angeschlossen ist, ist es möglich, das erste Ausgangssignal des ersten Strom-Messsignal-Wandlers mit dem zweiten Ausgangssignal, das von dem zweiten Strom-Messsignal-Wandler zur Verfügung gestellt wird, zu vergleichen. Dadurch kann in vorteilhafter Weise - insbesondere unter dem Gesichtspunkt der Fehlersicherheit - erreicht werden, mögliche Fehler der Strom-Messsignal-Wandler zu erkennen, wenn Abweichungen zwischen den von den Strom-Messsignal-Wandlern ausgegebenen Ausgangssignalen einen vorbestimmten oder vorbestimmbaren Grenzwert überschreiten. Die Prüfeinrichtung kann eine separate (insbesondere analoge) Baugruppe oder Bauteilkomponente, insbesondere ein Komparator, sein, die an die beiden Strom-Messsignal-Wandler angeschlossen ist. Alternativ kann auch vorgesehen sein, dass die Prüfeinrichtung Teil einer Auswerte- und Steuereinheit einer Sicherheitsschaltvorrichtung ist, welche die hier vorgestellte Eingangsschaltung aufweist. Bei der erfindungsgemäßen Eingangsschaltung ist vorgesehen, dass die Strombegrenzungseinrichtung einen Längsregler bildet, der einen Bipolartransistor sowie eine Z-Diode mit einem Vorwiderstand umfasst. Mittels der in Sperrrichtung geschalteten Z-Diode kann eine wirksame Spannungsbegrenzung erreicht werden, so dass Überspannungen innerhalb der Eingangsschaltung, die unter Umständen zu Beschädigungen, insbesondere zu Beschädigungen der Shunt-Widerstände, führen können, wirksam verhindert werden können. Der Bipolartransistor kann insbesondere als npn- oder als pnp-Transistor ausgeführt sein. Vorzugsweise kann der Bipolartransistor als Emitterfolger geschaltet sein.

In einer bevorzugten Ausführungsform wird vorgeschlagen, dass jede der Strommesseinrichtungen einen Shunt-Widerstand sowie einen parallel dazu geschalteten Verstärker, insbesondere einen Operationsverstärker, zur Messung und Verstärkung einer über dem Shunt-Widerstand abfallenden Spannung aufweist. Die Operationsverstärker können zum Beispiel als Instrumentenverstärker ausgebildet sein. Die Strommesseinrichtungen bilden somit Strom-Spannungswandler, bei denen die Stromstärke indirekt durch die Messung der Spannung, die über den Shunt-Widerständen abfällt, bestimmt wird. Derartige Strommesseinrichtungen zeichnen sich durch eine hohe Messgenauigkeit sowie durch eine robuste Bauform aus. Dadurch, dass beide Strom-Messsignal-Wandler eine Strommesseinrichtung aufweisen, ergibt sich eine unter dem Aspekt der Fehlersicherheit besonders vorteilhafte Redundanz.

In einer vorteilhaften Ausführungsform besteht die Möglichkeit, dass der Bipolartransistor einen Emitter und einen Kollektor aufweist, zwischen denen ein Widerstand zur Aufnahme einer Verlustleistung bei Anliegen einer Überspannung an der Eingangsschaltung vorgesehen ist. Im Überspannungsfall, der durch eine Durchbruchsspannung der Z-Diode definiert ist, kann ein Teil des Eingangsstroms durch den Widerstand zwischen dem Emitter und dem Kollektor fließen. Dadurch kann ein Teil der elektrischen Verlustleistung von diesem Widerstand aufgenommen werden, so dass das Risiko einer Beschädigung des Bipolartransistors im Falle einer Überspannung verringert werden. Diese Ausführungsform ist vorteilhaft, wenn der Bipolartransistor als npn- oder als pnp-Transistor ausgeführt ist.

In einer bevorzugten Ausführungsform wird vorgeschlagen, dass zwischen dem ersten Eingangsanschluss der Eingangsschaltung und dem Emitter des Bipolartransistors ein Widerstand zur Vorgabe eines Grenzstroms vorgesehen ist.

In einer vorteilhaften Weiterbildung besteht die Möglichkeit, dass die Eingangsschaltung eine Testeinrichtung umfasst, die so ausgebildet ist, dass sie die Funktion der Strombegrenzungseinrichtung testen kann. Somit können mögliche Fehler der Strombegrenzungseinrichtung erfasst werden, so dass aus diesen Fehlern resultierende Funktionseinschränkungen der Eingangsschaltung erkannt werden können.

Die Testeinrichtung kann in ganz unterschiedlicher Weise ausgeführt sein.

In einer ersten Ausführungsvariante kann die Testeinrichtung dazu ausgebildet sein, eine elektrische Spannung zu messen, die zwischen dem ersten Eingangsanschluss und dem zweiten Eingangsanschluss der Eingangsschaltung abfällt.

In einer zweiten Ausführungsvariante kann die Testeinrichtung dazu ausgebildet sein, eine elektrische Spannung zu messen, die über der Strom begrenzungseinrichtung abfällt.

In einer weiteren Ausführungsvariante kann die Testeinrichtung dazu ausgebildet sein, eine elektrische Spannung zu messen, die über der Strombegrenzungseinrichtung und der Strommesseinrichtung des ersten Strom-Messsignal-Wandlers abfällt.

Die Testeinrichtung kann einen vorzugsweise als Operationsverstärker ausgeführten Verstärker, insbesondere einen Instrumentenverstärker, umfassen, der den entsprechenden Spannungsabfall messen und als Ausgangssignal ein verstärktes Spannungssignal ausgeben kann. Dieses Ausgangssignal kann zum Beispiel mittels eines Analog-Digital-Wandlers digitalisiert werden und insbesondere einer Auswerte- und Steuereinheit einer Sicherheitsschaltvorrichtung zugeführt werden, die die Eingangsschaltung umfasst. Die Auswerte- und Steuereinheit kann das Ausgangssignal auswerten, insbesondere mit einem vorgegebenen Wert vergleichen, um mögliche Fehler der Strombegrenzungseinrichtung zu erfassen. Die Testeinrichtung kann auch einen analogen Komparator umfassen, mittels dessen ein derartiger Vergleich durchgeführt werden kann.

Eine erfindungsgemäße Sicherheitsschaltvorrichtung zeichnet sich dadurch aus, dass die Eingangsschaltung nach einem der Ansprüche 1 bis 9 ausgeführt ist. Durch die besondere Gestaltung der Eingangsschaltung, deren Merkmale und Vorteile oben ausführlich erläutert wurden, wird in vorteilhafter Weise ein verbesserter Schutz der Eingangsschaltung vor Beschädigungen, insbesondere durch Überspannungen, erreicht.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen:
- Fig. 1: ein Blockschaltbild, das Einzelheiten eines Signalverlaufs einer Sicherheitsschaltvorrichtung zeigt, die an ein Sensormittel sowie an zwei Stellglieder zur Ansteuerung eines Verbrauchers in einer automatisiert arbeitenden technischen Anlage angeschlossen ist,
- Fig. 2: eine Eingangsschaltung für die Sicherheitsschaltvorrichtung in Fig. 1, die gemäß einem ersten Ausführungsbeispiel der Erfindung ausgeführt ist,
- Fig. 3: eine Eingangsschaltung für die Sicherheitsschaltvorrichtung in Fig. 1, die gemäß einem zweiten Ausführungsbeispiel der Erfindung ausgeführt ist.

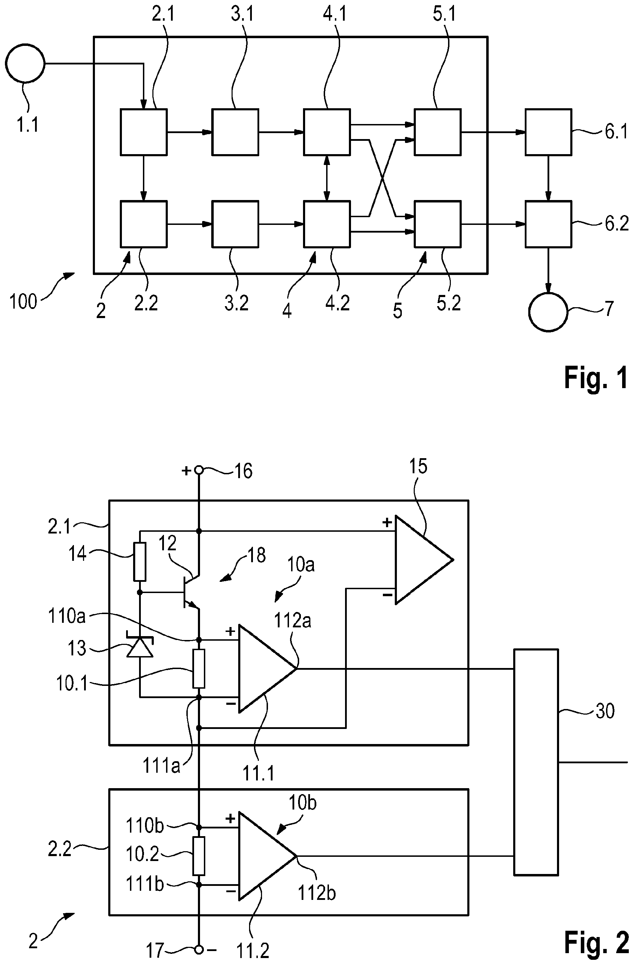

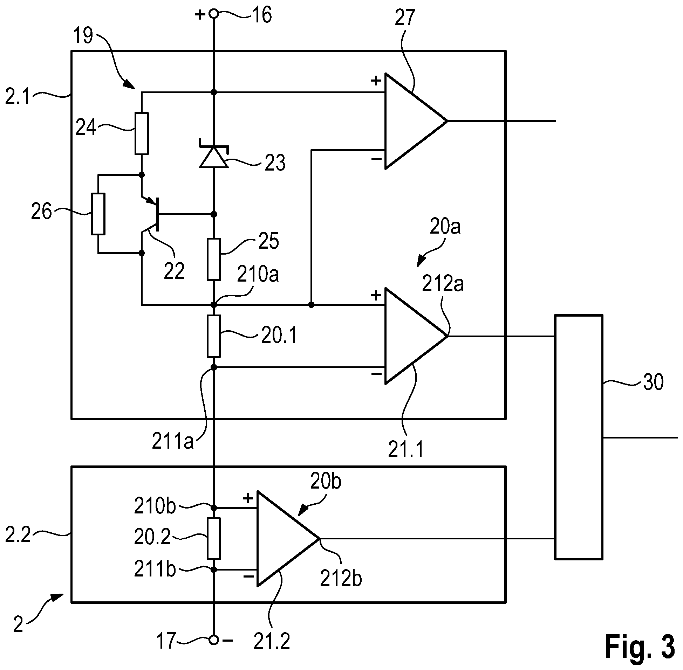

Unter Bezugnahme auf Fig. 1 sollen nachfolgend zunächst Einzelheiten des grundlegenden Aufbaus einer Sicherheitsschaltvorrichtung 100 für eine automatisiert arbeitende technische Anlage näher erläutert werden. Die Sicherheitsschaltvorrichtung 100 ist an einen Sensor 1.1 angeschlossen und weist eine Eingangsschaltung 2 auf, die dazu ausgebildet ist, ein analoges Eingangssignal von dem Sensor 1.1 zu empfangen und darin in ein weiterverarbeitbares Messsignal zu wandeln. Die Eingangsschaltung 2 weist zu diesem Zweck einen ersten Strom-Messsignal-Wandler 2.1 und einen zweiten Strom-Messsignal-Wandler 2.2 auf. Einzelheiten dieser Eingangsschaltung 2 mit den beiden Strom-Messsignal-Wandlern 2.1, 2.2 werden weiter unten unter Bezugnahme auf Fig. 2 und 3 noch näher erläutert. In der Sicherheitsschaltvorrichtung 100 ist aus Gründen der Redundanz eine zweikanalige, sich teilweise kreuzende Signalführung implementiert, wobei die einzelnen Signalpfade in Fig. 1 durch entsprechende Pfeile symbolisiert wurden.

Der erste Strom-Messsignal-Wandler 2.1 ist an einen ersten A/D-Wandler (Analog-Digital-Wandler) 3.1 angeschlossen, der ein von dem ersten Strom-Messsignal-Wandler 2.1 zur Verfügung gestelltes erstes analoges Ausgangssignal in ein digitales Signal wandelt. Der zweite Strom-Messsignal Wandler 2.2 ist an einen zweiten A/D-Wandler (Analog-Digital-Wandler) 3.2 angeschlossen, der ein von dem zweiten Strom-Messsignal-Wandler 2.2 zur Verfügung gestelltes zweites analoges Ausgangssignal in ein digitales Signal wandelt. Die beiden A/D-Wandler 3.1, 3.2 sind an eine Auswerte- und Steuereinheit 4 angeschlossen, die dazu eingerichtet ist, die von den beiden A/D-Wandlern 3.1, 3.2 generierten digitalen Signale zu verarbeiten und auszuwerten.

Die Auswerte- und Steuereinheit 4 ist hier zweikanalig redundant aufgebaut, was in Fig. 1 anhand von zwei Mikrocontrollern 4.1, 4.2 stark vereinfacht dargestellt wurde. Die Auswerte- und Steuereinheit 4 kann zum Beispiel die CPU einer programmierbaren Sicherheitssteuerung sein, wie sie von der Anmelderin der vorliegenden Erfindung unter der Bezeichnung PSS® vertrieben wird. Alternativ hierzu kann die Auswerte- und Steuereinheit 4 auch Teil eines Sicherheitsschaltgeräts sein, wie es von der Anmelderin der vorliegenden Erfindung unter der Bezeichnung PNOZ® in verschiedenen Varianten angeboten wird, oder es handelt sich um ein Kopfmodul für einen modulartigen Aufbau der Sicherheitsschaltvorrichtung 1. Die beiden Mikrocontroller 4.1, 4.2 können sich insbesondere wechselseitig auf mögliche Fehlfunktionen überwachen und/oder Daten untereinander austauschen.

Die Sicherheitsschaltvorrichtung 1 weist ferner einen Ausgang 5 mit zwei redundanten Ausgangsstufen 5.1, 5.2 auf, wobei jeder der beiden Mikrocontroller 4.1, 4.2 an jede der beiden Ausgangsstufen 5.1, 5.2 angeschlossen ist, um diese abhängig von den von der Auswerte- und Steuereinheit 4 verarbeiteten und ausgewerteten digitalen Signale ansteuern zu können. Hierdurch wird ebenfalls eine unter Sicherheitsaspekten, insbesondere unter dem Aspekt der Fehlersicherheit, vorteilhafte Redundanz geschaffen.

Die Ausgangsstufen 5.1, 5.2 der Sicherheitsschaltvorrichtung 1 sind jeweils an ein Stellglied 6.1, 6.2 angeschlossen. Eine erste Ausgangsstufe 5.1 des Ausgangs 5 ist dabei an ein erstes Stellglied 6.1 (einen ersten Aktor) angeschlossen. Eine zweite Ausgangsstufe 5.2 des Ausgangs 5 ist demgegenüber an ein zweites Stellglied 6.2 (einen zweiten Aktor) angeschlossen. Die beiden Stellglieder 6.1, 6.2 sind elektrisch in Reihe geschaltet und an einen Verbraucher 7 in der automatisiert arbeitenden technischen Anlage angeschlossen. Beide Stellglieder 6.1, 6.2 sind an den Verbraucher 7 angeschlossen, so dass dieser erforderlichenfalls fehlersicher abgeschaltet werden kann.

Unter Bezugnahme auf Fig. 2 soll nachfolgend ein erstes Ausführungsbeispiel der Eingangsschaltung 2 der Sicherheitsschaltvorrichtung 100 näher erläutert werden. Wie oben bereits erwähnt, weist die Eingangsschaltung 2 die beiden Strom-Messsignal-Wandler 2.1, 2.2 auf, die elektrisch in Reihe geschaltet sind und ein analoges Eingangssignal von dem Sensor 1.1 empfangen können. Zu diesem Zweck weist die Eingangsschaltung 2 einen Differenzeingang auf, der durch einen ersten Eingangsanschluss 16 (+) und einen zweiten Eingangsanschluss 17 (-) gebildet ist. Der Sensor 1.1 kann insbesondere als so genannter 2-Leitersensor ausgebildet sein, bei dem die Energieversorgung sowie das analoge Messsignal über eine gemeinsame Leitung geführt werden. Das analoge Messsignal wird der Eingangsschaltung 2 über die beiden Eingangsanschlüsse 16, 17 als Eingangssignal, welches vorliegend ein Stromsignal ist, zur Verfügung gestellt. Bei dem Sensor 1.1 kann es sich insbesondere um einen Druck-, Temperatur-, Drehzahl- oder Durchflusssensor handeln.

Vorzugsweise kann der analoge Sensor 1.1 so ausgelegt sein, dass er ein analoges Stromsignal liefern kann, dessen nutzbarer Signalbereich zwischen 4 mA und 20 mA liegt. Der durch die beiden Eingangsanschlüsse 16, 17 gebildete Differenzeingang kann somit insbesondere als standardisierte 4 mA bis 20 mA Eingangsschnittstelle ausgebildet sein. Bei einem Null-Signal des Sensors 1.1 fließt dabei immer noch ein Strom von 4 mA, so dass der Sensor 1.1 im gesamten Signalbereich und somit auch am Messbereichsanfang mit Energie versorgt werden kann. Die Eingangsschaltung 2 kann vorzugsweise dazu eingerichtet sein, Ströme in einem Bereich zwischen 0 mA und 25 mA zu messen. Werden Eingangssignale erfasst, die außerhalb des eigentlichen Arbeitsbereichs zwischen 4 mA und 20 mA liegen, werden diese als Fehler gewertet.

Der erste Strom-Messsignal-Wandler 2.1 weist eine Strommesseinrichtung 10a auf, die in diesem Ausführungsbeispiel durch einen Shunt-Widerstand 10.1, der zur indirekten Messung der elektrischen Stromstärke verwendet wird, und durch einen Operationsverstärker 11.1, insbesondere durch einen Instrumentenverstärker, gebildet ist, die parallel zueinander geschaltet sind. Die Strommesseinrichtung 10a des ersten Strom-Messsignal-Wandlers 2.1 umfasst einen ersten Eingang 110a, einen zweiten Eingang 111a und einen Ausgang 112a, der zum Ausgeben eines ersten (analogen) Ausgangssignals vorgesehen ist, wobei der erste Eingang 110a über eine Strombegrenzungseinrichtung 18 mit dem ersten Eingangsanschluss 16 der Eingangsschaltung 2 verbunden ist.

Der zweite Strom-Messsignal-Wandler 2.2 weist eine Strommesseinrichtung 10b auf, die in dem vorliegenden Ausführungsbeispiel durch einen Shunt-Widerstand 10.2, der zur indirekten Messung der elektrischen Stromstärke verwendet wird, sowie durch einen Operationsverstärker 11.2 gebildet ist, die ebenfalls parallel zueinander geschaltet sind. Die Strommesseinrichtung 10b des zweiten Strom-Messsignal-Wandlers 2.2 umfasst einen ersten Eingang 110b, einen zweiten Eingang 111b und einen Ausgang 112b, der zum Ausgeben eines zweiten (analogen) Ausgangssignals vorgesehen ist, wobei der zweite Eingang 111b mit dem zweiten Eingangsanschluss 17 der Eingangsschaltung 2 verbunden ist.

Da die beiden Strom-Messsignal-Wandler 2.1, 2.2 elektrisch in Reihe geschaltet sind, ist der zweite Eingang 111a der ersten Strommesseinrichtung 10a mit dem ersten Eingang 110b der zweiten Strommesseinrichtung 10b verbunden. Die Shunt-Widerstände 10.1, 10.2 sind niederohmig ausgeführt und können zum Beispiel einen (identischen) Widerstandswert von 50 Ohm haben.

Die beiden Strommesseinrichtungen 10a, 10b bilden aus funktionaler Sicht zwei Strom-Spannungswandler. Wenn ein elektrischer Strom durch die beiden Shunt-Widerstände 10.1, 10.2 fließt, bewirkt dieser zwischen den jeweiligen Eingängen 110a, 111a beziehungsweise 110b, 111b der Strommesseinrichtungen 10a, 10b einen Spannungsabfall. Dieser Spannungsabfall ist dabei nach dem Ohmschen Gesetz proportional zur Stromstärke. Die Operationsverstärker 11.1, 11.2 dienen dem Zweck, das gemessene Spannungssignal zu verstärken, so dass dieses verstärkte Signal als Ausgangssignal ausgegeben werden kann. Aufgrund der elektrischen Reihenschaltung der Strom-Messsignal-Wandler 2.1, 2.2 ist der Strom, der im Normalbetrieb durch die Strommesseinrichtungen 10a, 10b fließt, identisch. Bei identisch dimensionierten Shunt-Widerständen 10.1, 10.2 entspricht somit der von der Strommesseinrichtung 10a des ersten Strom-Messsignal-Wandlers 2.1 am Shunt-Widerstand 10.1 gemessene Spannungsabfall demjenigen Spannungsabfall am Shunt-Widerstand 10.2 der Strommesseinrichtung 10b des zweiten Strom-Messsignal-Wandlers 2.2.

Darüber hinaus weist die Eingangsschaltung 2 eine Prüfeinrichtung 30 zum Prüfen der Funktion der Strommesseinrichtung 10a des ersten Strom-Messsignal-Wandlers 2.1 und der Strommesseinrichtung 10b des zweiten Strom-Messsignal-Wandlers 2.2 auf, die derart gestaltet ist, dass sie die Ausgangssignale der beiden Strommesseinrichtungen 10a, 10b, die - wie zuvor erläutert - verstärkte Spannungssignale sind, miteinander vergleichen und eine mögliche Abweichung ermitteln kann. Wenn die Abweichung der Ausgangssignale einen vorbestimmten oder vorbestimmbaren Grenzwert überschreitet, der auf einen Fehler der Strommesseinrichtungen 10a, 10b hindeutet, kann die Prüfeinrichtung 30 der Auswerte- und Steuereinheit 4 der Sicherheitsschaltvorrichtung 100 ein entsprechendes Fehlersignal zur Verfügung stellen. Alternativ kann die Prüfeinrichtung 30 auch in der Auswerte- und Steuereinheit 4 implementiert sein.

Der erste Strom-Messsignal-Wandler 2.1 der Eingangsschaltung 2 weist ferner die oben bereits erwähnte Strombegrenzungseinrichtung 18 auf, die zwischen dem ersten Eingangsanschluss 16 und der Strommesseinrichtung 10a des ersten Strom-Messsignal-Wandlers 2.1 ausgebildet ist und die dazu eingerichtet ist, einen Maximalstrom, der durch den ersten Strom-Messsignal-Wandler 2.1 fließt und aufgrund der elektrischen Reihenschaltung folglich auch durch den zweiten Strom-Messsignal-Wandler 2.2 fließen würde, zu begrenzen.

Die Strombegrenzungseinrichtung 18 hat die Funktion eines Längsreglers und weist in diesem Ausführungsbeispiel eine Z-Diode 13 sowie einen Bipolartransistor 12 auf. Ein Vorwiderstand 14 ist dabei zwischen den ersten Eingangsanschluss 16 der Eingangsschaltung 2 und die Z-Diode 13 zur Begrenzung des im Durchbruchsfall durch die Z-Diode 13 fließenden Stroms geschaltet. Der Vorwiderstand 14 kann zum Beispiel eine Größe von 4,7 kOhm haben. Der Bipolartransistor 12 ist in diesem Ausführungsbeispiel ein npn-Transistor mit einer Basis, einem Emitter und einem Kollektor, welcher als Emitterfolger (und somit in einer Kollektorschaltung) geschaltet ist, so dass der Kollektor des Bipolartransistors 12 mit dem ersten Eingangsanschluss 16 der Eingangsschaltung 2, an dem eine positive Spannung anliegt, verbunden ist. Die Basis des Bipolartransistors 12 ist zwischen den Vorwiderstand 14 und die Z-Diode 13 geschaltet. Die Z-Diode 13 gibt eine Grenzspannung für die Eingangsschaltung 2 vor, die durch die Durchbruchsspannung der Z-Diode 13 definiert ist und zum Beispiel 5,6 V betragen kann.

Im Normalbetrieb, in dem die Spannung kleiner als die Durchbruchsspannung der Z-Diode 13 ist, fließt ein kleiner Basis-Emitter-Strom und steuert so einen relativ hohen Emitter-Kollektor-Strom. Der Bipolartransistor 12 wirkt in dieser Betriebsart somit wie ein geschlossener Schalter. Der Bipolartransistor 12 ist dazu in der Lage, bei Erreichen der durch die Z-Diode 13 vorgegebenen Grenzspannung (=Durchbruchsspannung) den Stromfluss durch den ersten Strom-Messsignal-Wandler 2.1 zu begrenzen. Die Spannung am Shunt-Widerstand 10.1 der Strommesseinrichtung 10a des ersten Strom-Messsignal-Wandlers 2.1 wird begrenzt und damit auch der Strom, der durch die Shunt-Widerstände 10.1, 10.2 der beiden Strommesseinrichtungen 10a, 10b fließt. Der durch die Größe des Vorwiderstands 14 der Z-Diode 13 begrenzte Strom fließt im Durchbruchsfall durch die Z-Diode 13 und anschließend durch den zweiten Strom-Messsignal-Wandler 2.2. Da im Durchbruchsfall der Strom durch den Shunt-Widerstand 10.1 des ersten Strom-Messsignal-Wandlers 2.1 begrenzt wird und ein durch den Vorwiderstand 14 begrenzter Strom durch die Z-Diode 13 in den zweiten Strom-Messsignal-Wandler 2.2 fließt, können Beschädigungen des Shunt-Widerstands 10.1 der Strommesseinrichtung 10a des ersten Strom-Messsignal-Wandlers 2.1 sowie des Shunt-Widerstands 10.2 der Strommesseinrichtung 10b des zweiten Strom-Messsignal-Wandlers 2.2, der mit dem ersten Strom-Messsignal-Wandler 2.1 elektrisch in Reihe geschaltet ist, in vorteilhafter Weise verhindert werden.

Darüber hinaus umfasst die Eingangsschaltung eine Testeinrichtung 15, die dem Zweck dient, die ordnungsgemäße Funktion der Strombegrenzungseinrichtung 18 zu testen. In dem hier gezeigten Ausführungsbeispiel weist die Testeinrichtung 15 einen Operationsverstärker 15.1, insbesondere einen Instrumentenverstärker, auf, der dazu eingerichtet ist, eine Spannung zu messen und zu verstärken, die aufgrund des Stromflusses über der Strombegrenzungseinrichtung 18 und der Strommesseinrichtung 10a des ersten Strom-Messsignal-Wandlers 2.1 abfällt. Dieser gemessene Spannungsabfall bildet zunächst ein analoges Signal, das nach einer entsprechenden Wandlung in ein digitales Signal von der Auswerte- und Steuereinheit 4 empfangen und ausgewertet und mit einem vorgegebenen Spannungsgrenzwert verglichen werden kann. Wird der Spannungsgrenzwert überschritten, erzeugt die Auswerte- und Steuereinheit 4 ein entsprechendes Fehlersignal. In einer alternativen Ausführungsform kann die Testeinrichtung 15 auch derart ausgeführt sein, dass sie eine Spannung, die zwischen dem ersten Eingangsanschluss 16 und dem zweiten Eingangsanschluss 17 abfällt, messen kann. Wird der Spannungsgrenzwert überschritten, erzeugt die Auswerte- und Steuereinheit 4 ein entsprechendes Fehlersignal. Grundsätzlich ist in beiden vorstehend beschriebenen Varianten auch eine unmittelbare Auswertung des gemessenen Spannungsabfalls in der Testeinrichtung 15 möglich, wenn die Testeinrichtung 15 einen analogen Komparator umfasst, der den gemessenen Spannungsabfall mit einem Spannungsgrenzwert vergleichen kann.

Unter Bezugnahme auf Fig. 3 soll nachfolgend ein zweites Ausführungsbeispiel der Eingangsschaltung 2 näher erläutert werden. Die Eingangsschaltung 2 weist ebenfalls die beiden Strom-Messsignal-Wandler 2.1, 2.2 auf, die elektrisch in Reihe geschaltet sind und im Betrieb ein analoges Eingangssignal, das vorliegend wiederum ein analoges Stromsignal ist, von dem Sensor 1.1 empfangen können. Zu diesem Zweck weist die Eingangsschaltung einen Differenzeingang auf, der durch einen ersten Eingangsanschluss 16 und einen zweiten Eingangsanschluss 17 gebildet ist. Der Sensor 1.1 kann - wie oben bereits erläutert - insbesondere als so genannter 2-Leitersensor ausgeführt sein, bei dem die Energieversorgung sowie das analoge Messsignal, über eine gemeinsame Leitung geführt werden. Das analoge Messsignal, welches ein analoges Stromsignal ist, wird der Eingangsschaltung 2 über die beiden Eingangsanschlüsse 16, 17 als Eingangssignal zur Verfügung gestellt. Der Sensor 1.1 kann insbesondere in der oben bereits erläuterten Weise ausgeführt sein und so ausgelegt sein, dass er ein analoges Stromsignal liefern kann, dessen nutzbarer Signalbereich zwischen 4 mA und 20 mA liegt.

Der erste Strom-Messsignal-Wandler 2.1 weist eine Strommesseinrichtung 20a auf, die in diesem Ausführungsbeispiel ebenfalls durch einen Shunt-Widerstand 20.1 sowie durch einen Operationsverstärker 21.1, insbesondere durch einen Instrumentenverstärker, gebildet ist, die parallel zueinander geschaltet sind. Die Strommesseinrichtung 20a des ersten Strom-Messsignal-Wandlers 2.1 umfasst einen ersten Eingang 210a, einen zweiten Eingang 211a und einen Ausgang 212a, der zum Ausgeben eines ersten Ausgangssignals vorgesehen ist, wobei der erste Eingang 210a über eine Strombegrenzungseinrichtung 19 mit dem ersten Eingangsanschluss 16 der Eingangsschaltung 2 verbunden ist.

Der zweite Strom-Messsignal-Wandler 2.2 weist ebenfalls eine Strommesseinrichtung 20b auf, die in dem vorliegenden Ausführungsbeispiel durch einen Shunt-Widerstand 20.2 sowie durch einen Operationsverstärker 21.2 gebildet ist, die parallel zueinander geschaltet sind. Die Strommesseinrichtung 20b des zweiten Strom-Messsignal-Wandlers 2.2 umfasst einen ersten Eingang 210b, einen zweiten Eingang 211b und einen Ausgang 212b, der zum Ausgeben eines zweiten Ausgangssignals vorgesehen ist, wobei der zweite Eingang 211b mit dem zweiten Eingangsanschluss 17 der Eingangsschaltung 2 verbunden ist.

Da die beiden Strom-Messsignal-Wandler 2.1, 2.2 elektrisch in Reihe geschaltet sind, ist der zweite Eingang 211a der ersten Strommesseinrichtung 20a mit dem ersten Eingang 210b der zweiten Strommesseinrichtung 20b verbunden. Die Shunt-Widerstände 20.1, 20.2 können zum Beispiel einen Widerstandswert von 50 Ohm haben.

Die beiden Strommesseinrichtungen 20a, 20b bilden aus funktionaler Sicht zwei Strom-Spannungswandler. Wenn ein elektrischer Strom durch die beiden Shunt-Widerstände 20.1, 20.2 fließt, bewirkt dieser Stromfluss zwischen den jeweiligen Eingängen 210a, 211a beziehungsweise 210b, 211b der Strommesseinrichtungen 20a, 20b einen Spannungsabfall. Dieser Spanungsabfall ist dabei nach dem Ohmschen Gesetz proportional zur Stromstärke. Die Operationsverstärker 21.1, 21.2 dienen dem Zweck, das gemessene Spannungssignal zu verstärken, so dass dieses verstärkte Signal als Ausgangssignal ausgegeben werden kann. Aufgrund der elektrischen Reihenschaltung der Strom-Messsignal-Wandler 2.1, 2.2 ist der Strom, der im Normalbetrieb durch die Strommesseinrichtungen 20a, 20b fließt, identisch. Bei identisch dimensionierten Shunt-Widerständen 20.1, 20.2 entspricht somit der von der Strommesseinrichtung 20a des ersten Strom-Messsignal-Wandlers 2.1 am Shunt-Widerstand 20.1 gemessene Spannungsabfall demjenigen Spannungsabfall am Shunt-Widerstand 20.2 der Strommesseinrichtung 20b des zweiten Strom-Messsignal-Wandlers 2.2.

Darüber hinaus weist die Eingangsschaltung 2 eine Prüfeinrichtung 30 zum Prüfen der Funktion der Strommesseinrichtung 20a des ersten Strom-Messsignal-Wandlers 2.1 und der Strommesseinrichtung 20b des zweiten Strom-Messsignal-Wandlers 2.2 auf, die derart gestaltet ist, dass sie die Ausgangssignale der beiden Strommesseinrichtungen 20a, 20b, die - wie zuvor erläutert - verstärkte Spannungssignale sind, miteinander vergleichen und eine mögliche Abweichung ermitteln kann. Wenn die Abweichung einen vorbestimmten oder vorbestimmbaren Grenzwert überschreitet, der auf einen Fehler der Strommesseinrichtungen 20a, 20b hindeutet, kann die Prüfeinrichtung 30 der Auswerte- und Steuereinheit 4 ein entsprechendes Fehlersignal zur Verfügung stellen. Alternativ kann die Prüfeinrichtung 30 auch in der Auswerte- und Steuereinheit 4 implementiert sein.

Der erste Strom-Messsignal-Wandler 2.1 der Eingangsschaltung 2 weist ferner die oben bereits erwähnte Strombegrenzungseinrichtung 19 auf, die zwischen dem ersten Eingangsanschluss 16 und der Strommesseinrichtung 20a des ersten Strom-Messsignal-Wandlers 2.1 ausgebildet ist und die dazu eingerichtet ist, einen Maximalstrom, der durch den ersten Strom-Messsignal-Wandler 2.1 und aufgrund der elektrischen Reihenschaltung auch durch den zweiten Strom-Messsignal-Wandler 2.2 fließt, zu begrenzen.

Die Strombegrenzungseinrichtung 19 weist in diesem Ausführungsbeispiel eine Z-Diode 23, der ein Vorwiderstand 25 zur Begrenzung des im Falle eines Spannungsdurchbruchs durch die Z-Diode 23 fließenden Stroms vorgeschaltet ist, sowie einen Bipolartransistor 22 auf, der vorliegend als pnp-Transistor ausgeführt ist, welcher eine Basis, einen Emitter und einen Kollektor aufweist und als Emitterfolger in einer Kollektorschaltung geschaltet ist. Der Vorwiderstand 25 der Z-Diode 23 kann zum Beispiel eine Größe von 10 kOhm haben. Die Basis des Bipolartransistors 22 ist zwischen die Z-Diode 23 und den Vorwiderstand 25 geschaltet. Die Z-Diode 23 ermöglicht bei der hier gezeigten Ausgestaltung der Strombegrenzungseinrichtung 19 eine Arbeitspunkteinstellung des Bipolartransistors 22 und gibt eine Grenzspannung für die Eingangsschaltung 2 vor, die durch die Durchbruchsspannung der Z-Diode 23 gegeben ist und zum Beispiel 2,7 V betragen kann. Dem Emitter des Bipolartransistors 22 ist ferner ein Vorwiderstand 24 vorgeschaltet, der zum Beispiel auf 56 Ohm dimensioniert sein kann und einen Grenzstrom vorgeben kann. Zwischen den Emitter und den Kollektor des Bipolartransistors 22 (und damit parallel zur Emitter-Kollektor-Strecke) ist ein Widerstand 26 geschaltet, der zum Beispiel auf 1 kOhm dimensioniert sein kann. Dieser Widerstand 26 ist dazu in der Lage, im Falle einer Überspannung, die zu einem Durchbruch der Z-Diode 23 führt, eine elektrische Verlustleistung aufzunehmen.

Im Normalbetrieb, in dem die Spannung kleiner als die Durchbruchsspannung der Z-Diode 23 ist, wirkt der Bipolartransistor 22 wie bereits im ersten Ausführungsbeispiel wie ein geschlossener Schalter, so dass ein relativ hoher Emitter-Kollektor-Strom fließt. Der Bipolartransistor 22 ist dazu in der Lage, bei Erreichen der durch die Z-Diode 23 vorgegebenen Grenzspannung den Stromfluss durch den ersten Messsignal-Wandler 2.1 zu begrenzen. Im Falle eines Spannungsdurchbruchs an der Z-Diode 23 wirkt der Bipolartransistor 22 dann wie ein Längsregler, so dass der Strom konstant gehalten wird. Ein durch die Größe des Vorwiderstands 24 und die Größe der Durchbruchsspannung der Z-Diode 23 begrenzter Strom fließt im Durchbruchsfall durch den Shunt-Widerstand 20.1 der Strommesseinrichtung 20a des ersten Strom-Messsignal-Wandlers 2.1 und anschließend durch den Shunt-Widerstand 20.2 der Strommesseinrichtung 20b des zweiten Strom-Messsignal-Wandlers 2.2. Darüber hinaus fließt mit zunehmendem Eingangsstrom (beziehungsweise auch bei zunehmender Überspannung) ein kleiner zunehmender Strom durch die Z-Diode 23 und durch den Vorwiderstand 25.

Da im Durchbruchsfall der Z-Diode 23 nur ein begrenzter Strom durch den Shunt-Widerstand 20.1 der Strommesseinrichtung 20a des ersten Strom-Messsignal-Wandlers 2.1 sowie durch den Shunt-Widerstand 20.2 der Strommesseinrichtung 20b des zweiten Strom-Messsignal-Wandlers 2.2 fließt, können Beschädigungen der Shunt-Widerstände 20.1, 20.2, die durch Überspannungen hervorgerufen werden können, in vorteilhafter Weise wirksam verhindert werden.

Darüber hinaus umfasst die Eingangsschaltung auch in diesem Ausführungsbeispiel eine Testeinrichtung 27, die dem Zweck dient, die ordnungsgemäße Funktion der Strombegrenzungseinrichtung 19 zu testen. In dem hier gezeigten Ausführungsbeispiel weist die Testeinrichtung 27 einen Operationsverstärker 27.1, insbesondere einen Instrumentenverstärker, auf, der dazu eingerichtet ist, eine Spannung zu messen und zu verstärken, die aufgrund des Stromflusses über der Strombegrenzungseinrichtung 19 abfällt. Dieser gemessene Spannungsabfall bildet zunächst ein analoges Signal, das nach einer entsprechenden Wandlung in ein digitales Signal von der Auswerte- und Steuereinheit 4 empfangen und ausgewertet und mit einem vorgegebenen Spannungsgrenzwert verglichen werden kann. Wird der Spannungsgrenzwert überschritten, so dass eine Überspannung herrscht, erzeugt die Auswerte- und Steuereinheit 4 ein entsprechendes Fehlersignal. In einer alternativen Ausführungsform kann die Testeinrichtung 27 auch derart ausgeführt sein, dass sie eine Spannung, die zwischen dem ersten Eingangsanschluss 16 und dem zweiten Eingangsanschluss 17 abfällt, messen kann. Wird der Spannungsgrenzwert überschritten, erzeugt die Auswerte- und Steuereinheit 4 ein entsprechendes Fehlersignal. Grundsätzlich ist in beiden vorstehend beschriebenen Varianten auch eine unmittelbare Auswertung des gemessenen Spannungsabfalls in der Testeinrichtung 27 möglich, wenn die Testeinrichtung 27 einen analogen Komparator umfasst, der den gemessenen Spannungsabfall mit einem Spannungsgrenzwert vergleichen kann.

Spannung zu messen und zu verstärken, die aufgrund des Stromflusses über der Strombegrenzungseinrichtung 19 abfällt. Dieser gemessene Spannungsabfall bildet zunächst ein analoges Signal, das nach einer entsprechenden Wandlung in ein digitales Signal von der Auswerte- und Steuereinheit 4 empfangen und ausgewertet und mit einem vorgegebenen Spannungsgrenzwert verglichen werden kann. Wird der Spannungsgrenzwert überschritten, so dass eine Überspannung herrscht, erzeugt die Auswerte- und Steuereinheit 4 ein entsprechendes Fehlersignal. In einer alternativen Ausführungsform kann die Testeinrichtung 27 auch derart ausgeführt sein, dass sie eine Spannung, die zwischen dem ersten Eingangsanschluss 16 und dem zweiten Eingangsanschluss 17 abfällt, messen kann. Wird der Spannungsgrenzwert überschritten, erzeugt die Auswerte- und Steuereinheit 4 ein entsprechendes Fehlersignal. Grundsätzlich ist in beiden vorstehend beschriebenen Varianten auch eine unmittelbare Auswertung des gemessenen Spannungsabfalls in der Testeinrichtung 27 möglich, wenn die Testeinrichtung 27 einen analogen Komparator umfasst, der den gemessenen Spannungsabfall mit einem Spannungsgrenzwert vergleichen kann.

## Patentansprüche

1. Eingangsschaltung (2) zum fehlersicheren Einlesen eines analogen Eingangssignals zumindest eines Sensors (1.1), umfassend
- einen ersten Eingangsanschluss (16) und einen zweiten Eingangsanschluss (17), an die der Sensor (1.1) anschließbar ist, sowie
- einen ersten Strom-Messsignal-Wandler (2.1), der an den ersten Eingangsanschluss (16) angeschlossen ist und eine erste Strommesseinrichtung (10a, 20a) aufweist, die im Betrieb der Eingangsschaltung (2) zur Bestimmung eines ersten Ausgangssignals aus dem analogen Eingangssignal eingerichtet ist,
- eine Strombegrenzungseinrichtung (18, 19), die innerhalb des ersten Strom-Messsignal-Wandlers (2.1) ausgebildet ist und die dazu eingerichtet ist, einen Maximalstrom, der im Betrieb durch den ersten Strom-Messsignal-Wandler (2.1) fließt, zu begrenzen,
- zumindest einen zweiten Strom-Messsignal-Wandler (2.2), der an den zweiten Eingangsanschluss (17) angeschlossen ist und eine zweite Strommesseinrichtung (10b, 20b) aufweist, die im Betrieb der Eingangsschaltung (2) zur Bestimmung eines zweiten Ausgangssignals aus dem analogen Eingangssignal eingerichtet ist, **dadurch gekennzeichnet,**
**dass** der erste Strom-Messsignal-Wandler (2.1) und der zweite Strom-Messsignal-Wandler (2.2) elektrisch in Reihe geschaltet sind, wobei ein zweiter Eingang der ersten Strommesseinrichtung mit einem ersten Eingang der zweiten Strommesseinrichtung verbunden ist,
und **dass**
die Eingangsschaltung (2) eine Prüfeinrichtung (30) umfasst, die an die beiden Strom-Messsignal-Wandler (2.1, 2.2) angeschlossen ist und die dazu eingerichtet ist, das erste Ausgangssignal mit dem zweiten Ausgangssignal zu vergleichen, um Fehler der Strom-Messsignal-Wandler (2.1, 2.2) zu erkennen, wenn Abweichungen zwischen den Ausgangssignalen einen vorbestimmten oder vorbestimmbaren Grenzwert überschreiten, und dass die Strombegrenzungseinrichtung (18, 19) einen Längsregler bildet, der einen Bipolartransistor (12, 22) sowie eine Z-Diode (13, 23) mit einem Vorwiderstand (14, 25) umfasst.

2. Eingangsschaltung (2) nach Anspruch 1, **dadurch gekennzeichnet, dass** jede der Strommesseinrichtungen (10a, 20a, 10b, 20b) einen Shunt-Widerstand (10.1, 10.2, 20.1, 20.2) sowie einen parallel dazu geschalteten Verstärker, insbesondere einen Operationsverstärker (11.1, 11.2, 21.1, 21.2), zur Messung und Verstärkung einer über dem Shunt-Widerstand (10.1, 10.2, 20.1, 20.2) abfallenden Spannung aufweist.

3. Eingangsschaltung (2) nach einem der Ansprüche 1 oder 2, **dadurch gekennzeichnet, dass** der Bipolartransistor (12, 22) als Emitterfolger geschaltet ist.

4. Eingangsschaltung (2) nach einem der Ansprüche 1 bis 3, **dadurch gekennzeichnet, dass** der Bipolartransistor (12, 22) einen Emitter und einen Kollektor aufweist, zwischen denen ein Widerstand (26) zur Aufnahme einer Verlustleistung bei Anliegen einer Überspannung an der Eingangsschaltung (2) vorgesehen ist.

5. Eingangsschaltung (2) nach Anspruch 4, **dadurch gekennzeichnet, dass** zwischen dem ersten Eingangsanschluss (16) der Eingangsschaltung (2) und dem Emitter des Bipolartransistors (12, 22) ein Widerstand (24) zur Vorgabe eines Grenzstroms vorgesehen ist.

6. Eingangsschaltung (2) nach einem der Ansprüche 1 bis 5, **dadurch gekennzeichnet, dass** die Eingangsschaltung (2) eine Testeinrichtung (15, 27) umfasst, die so ausgebildet ist, dass sie die Funktion der Strombegrenzungseinrichtung (18, 19) testen kann.

7. Eingangsschaltung (2) nach Anspruch 6, **dadurch gekennzeichnet, dass** die Testeinrichtung (15, 27) dazu ausgebildet ist, eine elektrische Spannung zu messen, die zwischen dem ersten Eingangsanschluss (16) und dem zweiten Eingangsanschluss (17) der Eingangsschaltung (2) abfällt.

8. Eingangsschaltung (2) nach Anspruch 6, **dadurch gekennzeichnet, dass** die Testeinrichtung (15, 27) dazu ausgebildet ist, eine elektrische Spannung zu messen, die über der Strombegrenzungseinrichtung (18, 19) abfällt.

9. Eingangsschaltung (2) nach Anspruch 6, **dadurch gekennzeichnet, dass** die Testeinrichtung (15, 27) dazu ausgebildet ist, eine elektrische Spannung zu messen, die über der Strombegrenzungseinrichtung (18, 19) und der Strommesseinrichtung (10a, 20a) des ersten Strom-Messsignal-Wandlers (2.1) abfällt.

10. Sicherheitsschaltvorrichtung (100) zum sicheren Abschalten eines Verbrauchers (7) in einer automatisiert arbeitenden technischen Anlage, umfassend
- eine Eingangsschaltung (2), die zum fehlersicheren Einlesen eines analogen Eingangssignals eines analogen Sensors (1.1) und zum Wandeln des analogen Eingangssignals in mindestens ein analoges Ausgangssignal eingerichtet ist,
- einen Analog-Digital-Wandler (3.1, 3.2), der dazu ausgebildet ist, das mindestens eine Ausgangssignal der Eingangsschaltung (2) in mindestens ein digitales Signal zu wandeln,
- eine Steuerungs- und Auswerteeinheit (4), die dazu ausgebildet ist, das digitale Signal des zumindest einen Analog-Digital-Wandlers (3.1, 3.2) zu empfangen und zu verarbeiten, sowie
- zumindest ein Stellglied (6.1, 6.2) das an die Steuerungs- und Auswerteeinheit (4) und an den Verbraucher (7) angeschlossen ist und in Abhängigkeit von dem digitalen Signal ansteuerbar ist,
**dadurch gekennzeichnet, dass** die Eingangsschaltung (2) nach einem der Ansprüche 1 bis 9 ausgeführt ist.

## Claims

1. Input circuit (2) for fail-safe reading of an analogue input signal of at least one sensor (1.1), comprising
- a first input connection (16) and a second input connection (17) to which the sensor (1.1) can be connected, and
- a first current-measuring signal converter (2.1) which is connected to the first input terminal (16) and comprises a first current measuring device (10a, 20a) which, during operation of the input circuit (2), is configured to determine a first output signal from the analogue input signal,
- a current limiting device (18, 19) which is arranged within said first current measurement signal converter (2.1) and which is configured to limit a maximum current flowing through the first current measurement signal converter (2.1) during operation,
- at least one second current-measuring signal converter (2.2) connected to the second input terminal (17) and comprising a second current measuring device (10b, 20b) which, during operation of the input circuit (2), is configured to determine a second output signal from the analogue input signal, **characterised in that** the first current-measuring signal converter (2.1) and the second current-measuring signal converter (2.2) are electrically connected in series, wherein a second input of the first current measuring device is connected to a first input of the second current measuring device,
and that the input circuit (2) comprises a test device (30) which is connected to the two current measuring signal converters (2.1, 2.2) and which is configured to compare the first output signal with the second output signal in order to detect faults in the current-measuring signal converters (2.1, 2.2) if deviations between the output signals exceed a predetermined or predeterminable limit value,
and that the current limiting device (18, 19) forms a series regulator comprising a bipolar transistor (12, 22) and a Z-diode (13, 23) with a series resistor (14, 25).

2. Input circuit (2) according to claim 1, **characterised in that** each of the current measuring devices (10a, 20a, 10b, 20b) has a shunt resistor (10.1, 10.2, 20.1, 20.2) and an amplifier connected in parallel therewith, in particular an operational amplifier (11.1, 11.2, 21.1, 21.2), for measuring and amplifying a voltage dropped across the shunt resistor (10.1, 10.2, 20.1, 20.2).

3. Input circuit (2) according to one of claims 1 or 2, **characterised in that** the bipolar transistor (12, 22) is connected as an emitter follower.

4. Input circuit (2) according to one of claims 1 to 3, **characterised in that** the bipolar transistor (12, 22) has an emitter and a collector between which a resistor (26) is provided to absorb a power loss when an overvoltage is applied to the input circuit (2).

5. Input circuit (2) according to claim 4, **characterised in that** a resistor (24) is provided between the first input terminal (16) of the input circuit (2) and the emitter of the bipolar transistor (12, 22) to provide a limit current.

6. Input circuit (2) according to one of claims 1 to 5, **characterised in that** the input circuit (2) comprises a test device (15, 27), which is designed to test the function of the current limiting device (18, 19).

7. Input circuit (2) according to claim 6, **characterised in that** the test device (15, 27) is designed to measure an electric voltage which drops between the first input terminal (16) and the second input terminal (17) of the input circuit (2).

8. Input circuit (2) according to claim 6, **characterised in that** the test device (15, 27) is designed to measure an electric voltage which drops across the current limiting device (18, 19).

9. Input circuit (2) according to claim 6, **characterised in that** the test device (15, 27) is designed to measure an electrical voltage which drops across the current limiting device (18, 19) and the current measuring device (10a, 20a) of the first current measuring signal converter (2.1).

10. Safety switching device (100) for the safe disconnection of a load (7) in an automated technical plant, comprising
- an input circuit (2) which is configured for fail-safe reading of an analogue input signal of an analogue sensor (1.1) and for converting the analogue input signal into at least one analogue output signal,
- an analogue-to-digital converter (3.1, 3.2), designed to convert the at least one output signal of the input circuit (2) into at least one digital signal,
- a control and analysis unit (4), designed to receive and process the digital signal of at least one analogue-to-digital converter (3.1, 3.2), and
- at least one actuator (6.1, 6.2) which is connected to the control and analysis unit (4) and to the load (7) and can be controlled depending on the digital signal,
**characterised in that** the input circuit (2) is designed according to one of the claims 1 to 9.

## Revendications

1. Circuit d'entrée (2) pour la lecture à l'épreuve des erreurs d'un signal d'entrée analogique d'au moins un capteur (1.1), comprenant
- une première borne d'entrée (16) et une seconde borne d'entrée (17), auxquelles le capteur (1.1) peut être raccordé, ainsi que
- un premier convertisseur de signal de mesure de courant (2.1), qui est raccordé à la première borne d'entrée (16) et présente un premier dispositif de mesure de courant (10a, 20a), qui est configuré, pendant le fonctionnement du circuit d'entrée (2), pour établir un premier signal de sortie à partir du signal d'entrée analogique,
- un dispositif de limitation de courant (18, 19), qui est agencé à l'intérieur du premier convertisseur de signal de mesure de courant (2.1), et qui est configuré pour limiter un courant maximal qui circule pendant le fonctionnement à travers le premier convertisseur de signal de mesure de courant (2.1),
- au moins un second convertisseur de signal de mesure de courant (2.2), qui est raccordé à la seconde borne d'entrée (17) et présente un second dispositif de mesure de courant (10b, 20b), qui est configuré, pendant le fonctionnement du circuit d'entrée (2), pour établir un second signal de sortie à partir du signal d'entrée analogique, **caractérisé en ce que** le premier convertisseur de signal de mesure de courant (2.1) et le second convertisseur de signal de mesure de courant (2.2) sont montés électriquement en série, selon lequel une seconde entrée du premier dispositif de mesure de courant est connectée à une première entrée du second dispositif de mesure de courant, et **en ce que** le circuit d'entrée (2) comprend un dispositif de contrôle (30) qui est raccordé aux deux convertisseurs de signal de mesure de courant (2.1, 2.2) et qui est configuré pour comparer le premier signal de sortie avec le second signal de sortie, afin de reconnaître des erreurs des convertisseurs de signal de mesure de courant (2.1, 2.2), lorsque des écarts entre les signaux de sortie dépassent une valeur limite prédéterminée ou prédéterminable, et **en ce que** le dispositif de limitation de courant (18, 19) constitue un régulateur série, qui comprend un transistor bipolaire (12, 22) ainsi qu'une diode de Zener (13, 23) avec une résistance série (14, 25).

2. Circuit d'entrée (2) selon la revendication 1, **caractérisé en ce que** chacun des dispositifs de mesure de courant (10a, 20a, 10b, 20b) présente une résistance de shunt (10.1, 10.2, 20.1, 20.2) ainsi qu'un amplificateur monté en parallèle avec elle, en particulier un amplificateur opérationnel (11.1, 11.2, 21.1, 21.2) pour mesurer et amplifier une tension chutant dans la résistance de shunt (10.1, 10.2, 20.1, 20.2).

3. Circuit d'entrée (2) selon l'une des revendications 1 ou 2, **caractérisé en ce que** le transistor bipolaire (12, 22) est monté comme un émetteur-suiveur.

4. Circuit d'entrée (2) selon l'une des revendications 1 à 3, **caractérisé en ce que** le transistor bipolaire (12, 22) présente un émetteur et un collecteur, entre lesquels une résistance (26) est prévue pour absorber une puissance dissipée lors de l'application d'une surtension au circuit d'entrée (2).

5. Circuit d'entrée (2) selon la revendication 4, **caractérisé en ce que**, entre la première borne d'entrée (16) du circuit d'entrée (2) et l'émetteur du transistor bipolaire (12, 22), une résistance (24) est prévue pour prédéfinir un courant limite.

6. Circuit d'entrée (2) selon l'une des revendications 1 à 5, **caractérisé en ce que** le circuit d'entrée (2) comprend un dispositif d'essai (15, 27) qui est agencé de façon qu'il puisse essayer le fonctionnement du dispositif de limitation de courant (18, 19).

7. Circuit d'entrée (2) selon la revendication 6, **caractérisé en ce que** le dispositif d'essai (15, 27) est agencé pour mesurer une tension électrique, qui chute entre la première borne d'entrée (16) et la seconde borne d'entrée (17) du circuit d'entrée (2).

8. Circuit d'entrée (2) selon la revendication 6, **caractérisé en ce que** le dispositif d'essai (15, 27) est agencé pour mesurer une tension électrique, qui chute dans le dispositif de limitation de courant (18, 19).

9. Circuit d'entrée (2) selon la revendication 6, **caractérisé en ce que** le dispositif d'essai (15, 27) est agencé pour mesurer une tension électrique, qui chute dans le dispositif de limitation de courant (18, 19) et le dispositif de mesure de courant (10a, 20a) du premier convertisseur de signal de mesure de courant (2.1).

10. Dispositif de commutation de sécurité (100) pour déconnecter de manière sûre un consommateur (7) dans une installation technique fonctionnant de manière automatisée, comprenant
- un circuit d'entrée (2), qui est configuré pour la lecture à l'épreuve des erreurs d'un signal d'entrée analogique d'un capteur analogique (1.1) et pour la conversion du signal d'entrée analogique en au moins un signal de sortie analogique,
- un convertisseur analogique-numérique (3.1, 3.2), qui est agencé pour convertir le au moins un signal de sortie du circuit d'entrée (2) en au moins un signal numérique,
- une unité de commande et d'évaluation (4) qui est agencée pour recevoir et traiter le signal numérique du moins un convertisseur analogique-numérique (3.1, 3.2), ainsi que
- au moins un actionneur (6.1, 6.2) qui est raccordé à l'unité de commande et d'évaluation (4) et au consommateur (7) et est commandable en fonction du signal numérique,
**caractérisé en ce que** le circuit d'entrée (2) est réalisé selon l'une des revendications 1 à 9.
